Europäisches Patentamt

European Patent Office

Office européen des brevets

(19)

(11) EP 0 588 274 B1

(12) **EUROPÄISCHE PATENTSCHRIFT**

(45) Veröffentlichungstag und Bekanntmachung des Hinweises auf die Patenterteilung:
**17.12.1997 Patentblatt 1997/51**

(51) Int Cl.⁶: **G06F 13/42**, G11C 5/06

(21) Anmeldenummer: **93114651.8**

(22) Anmeldetag: **13.09.1993**

(54) **Serielles Bus-System mit einer Eindrahtverbindung**

Serial bus-system having one-wire link

Système de bus série avec connexion à un fil

(84) Benannte Vertragsstaaten:
**DE FR NL**

(30) Priorität: **16.09.1992 DE 4230913**

(43) Veröffentlichungstag der Anmeldung:
**23.03.1994 Patentblatt 1994/12**

(73) Patentinhaber: **Deutsche ITT Industries GmbH**
**79108 Freiburg (DE)**

(72) Erfinder: **Heberle, Klaus, Dipl.-Ing.**
**D-79276 Reute (DE)**

(56) Entgegenhaltungen:
• **DATA COMMUNICATIONS. Bd. 15, Nr. 1 , Januar 1986 , NEW YORK US Seiten 171 - 175 J. DHUSE ET AL. 'Standard protocols are needed for distributed microcontrollers'**
• **ELEKTRONIK. Bd. 39, Nr. 10 , 11. Mai 1990 , MUNCHEN DE Seiten 140 - 143 XP117042 J. SORGENFREI ET AL. 'Schnittstellen-IC für den seriellen Kfz-Bus'**

**Beschreibung**

Die Erfindung betrifft bei einem seriellen Bussystem mit einer Eindrahtverbindung ein Verfahren und eine Schaltungsanordnung, um eine Eingabeschaltung mittels der Eindrahtverbindung an einen Prozessor anzuschließen. Derartige Verfahren und Schaltungsanordnungen sind bekannt, beispielsweise in der Fernwirktechnik, bei der Daten eines entfernten Gebers über eine Eindrahtverbindung, die z.B. auch eine Telefonverbindung sein kann, abgefragt werden und mit den abgefragten Signalen ein Prozessor gespeist wird. Zweckmäßig ist es dabei, die Daten des Gebers in digitaler Form zu übertragen, weil dann die Übertragung sicherer wird. Handelt es sich bei dem Geber um eine Mehrfachsignalquelle, dann lassen sich diese Signale im seriellen Multiplexbetrieb oder in codierter Form übertragen und werden im Prozessor wieder in die einzelnen Komponenten getrennt.

In "Patents Abstracts of Japan", P-622, Vol. 11, No. 303, 3. Oktober 1987, (JP 62-9564 A) wird ein serielles Übertragungssystem für asynchrone Daten beschrieben, bei dem die unidirektionale Datenübertragung von einer Masterauf eine Slave-Station mittels einer Eindrahtverbindung erfolgt. Bei diesem Übertragungssystem werden mittels eines mehrfachen "Handshake"-Verfahrens die binären Aufforderungs-, Quittungs- und Datenübertragungssignale für die serielle Übertragung bewirkt, wobei stets nur ein einziges Steuersignal über die Eindrahtverbindung zu übertragen ist.

Aufgabe der Erfindung ist es, ein Verfahren und eine Schaltungsanordnung anzugeben, die die Übermittlung der Signale eines Gebers an einen handelsüblichen Prozessor, insbesondere einen Mikroprozessor, ermöglichen, wobei die Übertragung und ihr zeitlicher Ablauf nur vom Prozessor gesteuert werden soll.

Es liegt ferner im Rahmen der Aufgabe, den Geber so auszubilden, daß das bzw. die Signale der Einfach- bzw. Mehrfachsignalquelle, die jeweils analog oder digital vorliegen können, in eine geeignete digitale Form gebracht werden, damit ein üblicher Ein-Pin Eingangs/Ausgangs-Prozessoranschluß (= I/O-Anschluß) die Signale übernehmen kann. Dies soll unabhängig davon sein, ob der Eingangs/Ausgangs-Prozessoranschluß einen Gegentaktausgang oder eine offene Ausgangsstufe aufweist.

Im Bereich der gestellten Aufgabe ist ferner die Funktionsweise des Gebers so auszubilden, daß möglichst jeder handelsübliche Prozessor mittels einer geeigneten Programmanweisung (= Software) in der Lage ist, den Ablauf des Datentelegramms von sich aus zu steuern.

Grundgedanke der Erfindung ist es, im Geber die zu übertragenden Signale als eine Zahl (= N) zu codieren, die als Impulsfolge, beispielsweise durch eine Anzahl von Einsen, innerhalb des Datentelegramms übertragen wird. Die Übertragungsabsicht eines Telegramms wird vom Geber dem Prozessor dadurch angezeigt, daß der Geber die im Nullzustand verriegelte Eindrahtverbindung freigibt und durch externe oder interne Schaltungsmittel in den Einszustand ziehen läßt. Dies erkennt der Prozessor und zieht die Eindrahtverbindung wieder zwangsweise in den Nullzustand. So entsteht nacheinander die Impulsfolge aus Einsen auf der Eindrahtverbindung. Im Geber werden diese Einsen gezählt und weitere Einsen auf der Eindrahtverbindung durch Verriegelung in den Nullzustand unterdrückt, wenn die Anzahl der gezählten Einsen mit der intern codierten Zahl N übereinstimmt.

Der Prozessor muß seinerseits nach jeder Eins prüfen, ob der Nullpegel-Verriegelungszustand bereits vorliegt. Zu diesem Zweck wird der Prozessoranschluß als Eingang hochohmig geschaltet und nach einem kurzen Einstellintervall der Spannungspegel auf der Eindrahtverbindung geprüft. Wenn der Geber die Eindrahtverbindung nicht im Nullpegel-Zustand verriegelt hat, dann ziehen die Schaltungsmittel, beispielsweise ein externer pull-up-Widerstand, die Eindrahtverbindung auf den Einspegel.

Zwischen dem Telegrammende und einem neuen Telegrammbeginn bildet der Geber ein Sperrintervall, in dem die Eindrahtverbindung auf dem Nullpotential festgehalten wird. Der Prozessor kann somit ebenfalls das Telegrammende erkennen und übernimmt die im Prozessor ebenfalls gezählte Anzahl von Einsen als codierte Zahl N.

Ein wesentlicher Vorteil der Erfindung besteht wie bereits angegeben darin, daß handelsübliche Prozessoren verwendet werden können und zum Anschluß eines Gebers nur ein einziger I/O-Prozessoranschluß erforderlich ist. Ein weiterer Vorteil besteht darin, daß der Geber lediglich drei Anschlußbeine erfordert und damit kostengünstig hergestellt werden kann. Als weiterer Vorteil der Erfindung ist ihre breite Anwendbarkeit zu nennen, die eine Vielzahl von peripheren Gebern, wie Sensoren, Geber, Drucktastenelemente und sogar einfache Speichereinrichtungen, wie z.B. ein Kennziffern-ROM, miteinschließen.

Die Erfindung wird nun anhand der Figuren der Zeichnung näher erläutert:

Fig. 1 zeigt schematisch als Blockschaltbild ein Ausführungsbeispiel des Gebers und diejenigen wesentlichen Schaltungsteile eines Prozessors, die über den Eingangs/Ausgangs-Anschluß mittels der Eindrahtverbindung an den Geber gekoppelt sind,

Fig. 2 zeigt den Zeitablauf einiger Signale der Schaltungsanordnung nach Fig. 1 und

Fig. 3 zeigt mittels eines Ablaufdiagramms die Übertragung eines Datentelegramms.

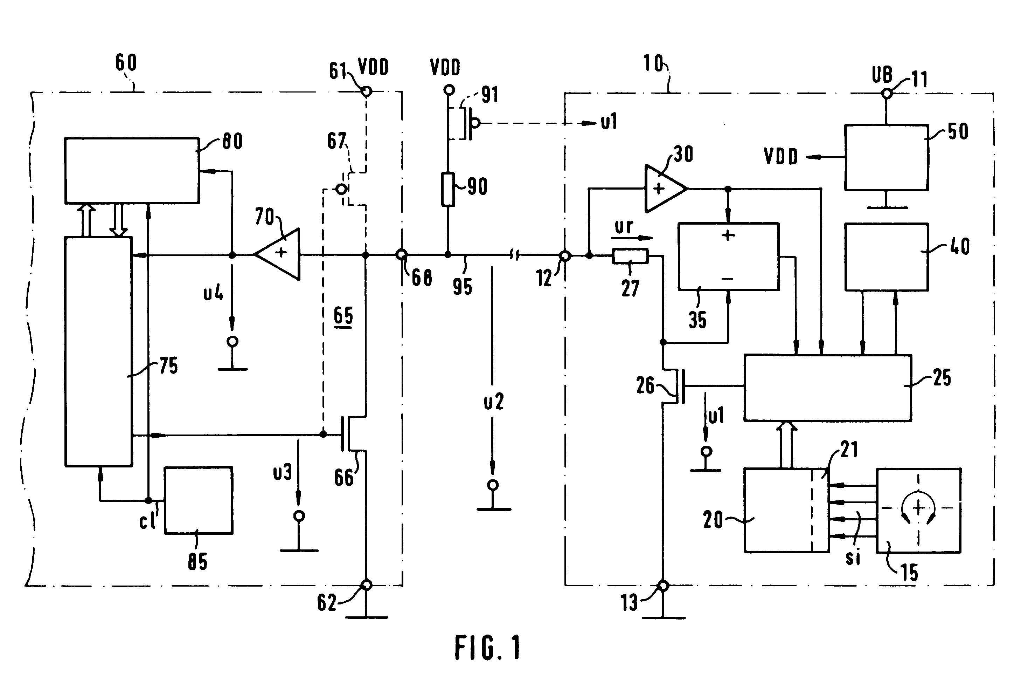

In Fig. 1 ist ein nur teilweise dargestellter Prozessor 60 im Bereich seines Eingangs/Ausgangs-Anschlusses 68, im folgenden Prozessoranschluß genannt, dargestellt. Im Ausgangsbetrieb ist der Prozessoranschluß 68 niederohmig und sein Spannungspegel wird von einer Ausgangsstufe 65 gesteuert, die entweder als Gegentaktstufe mit den Transistoren 66 und 67 oder als offene-Kollektorstufe oder als offene-Drain-Stufe mit dem Transistor 66 ausgebildet ist. Im Ausgangsbetrieb ist die Ausgangsstufe 65 hochohmig geschaltet, so daß der Prozessoranschluß 68 bezüglich seines Potentials schweben (=floaten) kann. In diesem Schaltzustand wird mittels einer Fühlerschaltung 70 das Potential am Prozessoranschluß 68 abgegriffen und mittels einer Schwellwertschaltung, die Teil der Fühlerschaltung 70 sein kann, als Null- oder Eins-Signal erkannt. Dieses Signal speist eine Eingangs/Ausgangs-Steuereinrichtung 75 und die angeschlossenen Datenverarbeitungstufen im Prozessor 60, die vereinfachend in Form eines Blokkes als Datenverarbeitungseinrichtung 80 dargestellt sind. Die Datenverarbeitungseinrichtung 80 enthält auch die festen und programmierbaren Programmabläufe und ist über Daten- und Steuerleitungen mit der Eingangs/Ausgangs-Steuereinrichtung 75 verbunden. Der erforderliche Systemtakt cl wird von außen zugeführt oder mittels eines Taktgebers 85 im Prozessor 60 selbst erzeugt.

Wenn der Prozessoranschluß 68 von der Eingangs/Ausgangs-Steuereinrichtung 75 als Ausgang geschaltet wird, dann muß nach der Erfindung gewährleistet sein, daß der Prozessoranschluß 68 niederomig auf einen festen Spannungspegel gezogen wird, der in der Regel durch den Masseanschluß 62 des Prozessors 60 gebildet wird. Das Potential des Masseanschlusses 62 soll dabei etwa dem Potential des Masseanschlusses 13 des Gebers 10 gleich sein. Für die Grundausführung der Erfindung ist es nicht erforderlich, daß der Prozessoranschluß 68 niederohmig auf den anderen Versorgungsanschluß 61, der etwa die positive Versorgungsspannung VDD aufweist, gezogen wird, weshalb der zugehörige pull-up-Transistor 67 in Fig. 1 nur gestrichelt dargestellt ist.

Die Beschreibung und das Ausführungsbeispiel nach Fig. 1 geht dabei davon aus, daß üblicherweise die offenen Drain-Anschlüsse den zugehörigen Prozessoranschluß 68 nur in Richtung eines niedrigeren Potentials aktiv ziehen können. Im folgenden ist in der Beschreibung unter einem ersten bzw. zweiten Spannungspegel 1 bzw. 0 ein positiverer bzw. negativerer Spannungspegel zu verstehen, der auch als Eins- bzw. Nullpegel oder auch als Eins- bzw. Nullsignal bezeichnet wird. Für die tatsächlichen Spannungen gelten die üblichen Schwellenwerte als Grenzpegel. Bei einer anderen Schaltungstechnologie ist gegebenenfalls die Vertauschung der Potentialangaben erforderlich.

Der Geber 10 weist lediglich drei Anschlußbeine auf, nämlich für eine beliebige positive Versorgungsspannung UB am Anschluß 11, die Masse am Anschluß 13 und schließlich die Daten am Ausgangsanschluß 12. Die positive Versorgungsspannung UB wird mittels einer internen Spannungsstufe 50 auf eine interne 5V-Versorgung herabgesetzt, auf die die üblichen Halbleiterherstellungsprozesse abgestimmt sind, insbesondere die CMOS-Technik.

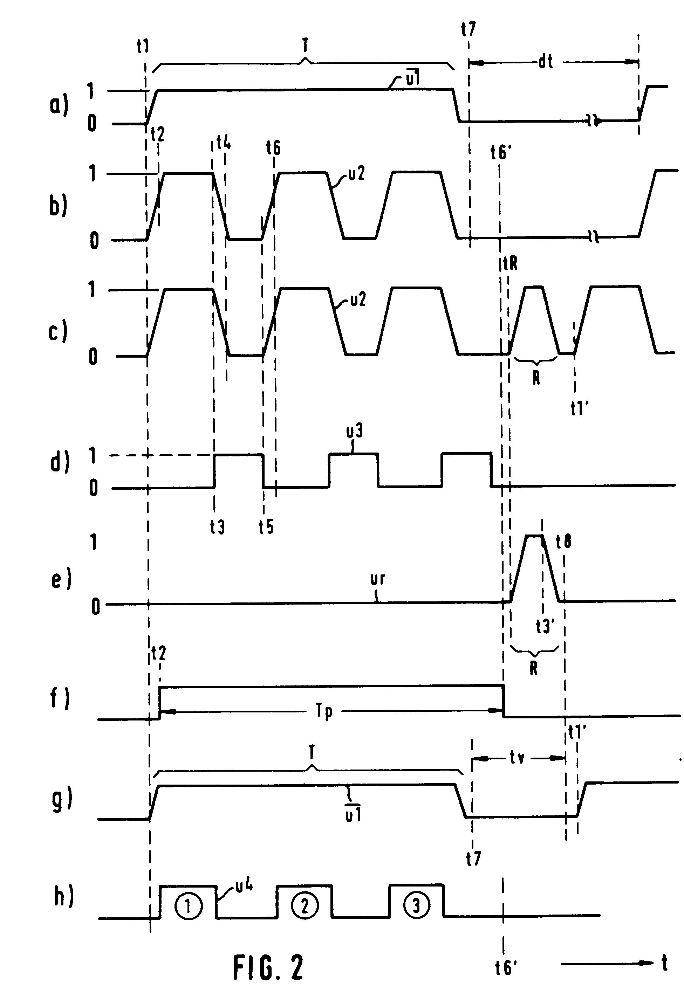

Am Ausgangsanschluß 12 ist eine Schalterstufe 26, 27 angeordnet, die aus der Serienschaltung eines Entkoppelwiderstandes 27 und eines Transistors 26 besteht, dessen Fußpunkt mit dem Masseanschluß 13 verbunden ist. Die Steuerelektrode des Schalttransistors 26 ist mit einer Ausgangssteuerschaltung 25 verbunden, der Daten aus einem Codierer 20 und ein Zeitsignal aus einem Zeitgeber 40, sowie die Ausgangssignale eines mit dem Ausgangsanschluß 12 gekoppelten Fühlers 30 und Vergleichers 35 zugeführt sind. Im einfachsten Fall besteht der Zeitgeber 40 aus einer RC-Verzögerungsstufe, die ein Ausgangssignal der Ausgangssteuerschaltung 25 verzögert, um dadurch die Dauer des Sperrintervalls dt, vgl. Fig. 2, zu bilden.

Dem Codierer 20 sind von einer Signalquelle 15 Eingabesignale si zugeführt, die im Codierer in eine Zahl N umgesetzt werden. Diese wird der Ausgangssteuerschaltung 25 zugeführt. Wenn die Signalquelle 15 Analogsignale liefert, deren jeweiliger Pegel eine bestimmte Information darstellt, dann sind diese Signale mittels eines Analog/Digitalumsetzers 21 im Codierer in digitale Signale umzusetzen, die dann im Codierer weiterverarbeitet werden, um die Zahl N als Ausgangszahl des Codierers 20 zu bilden.

Die Codierung soll an folgendem Beispiel, bei dem die Signalquelle 15 aus einem Drehgeber mit einem zusätzlichen Axialschalter besteht, ausführlicher erläutert werden: Die Eingabesignale si, die der Drehgeber abgibt, sind ein Rechts- und Linkslaufsignal sowie unabhängig davon ein Axialsignal, wenn der Axialschalter betätigt wurde. Für das Ausgangssignal des Codierers 20 ist es dabei unerheblich, ob die Eingabesignale si statisch sind oder als Impulse oder Impulsfolgen vorliegen. Der Codierer muß sie nur unterscheiden können. Folgende Kombinationen sind in diesem einfachen Beispiel denkbar, denen im Codierer 20 folgende Zahlen zugeordnet werden können:

Keine Funktion: N = 0; Rechtslauf: N = 1; Linkslauf: N = 2; Axialschalter betätigt: N = 3; Rechtslauf kombiniert mit betätigtem Axialschalter: N = 4; und schließlich Linkslauf kombiniert mit betätigtem Axialschalter: N = 5.

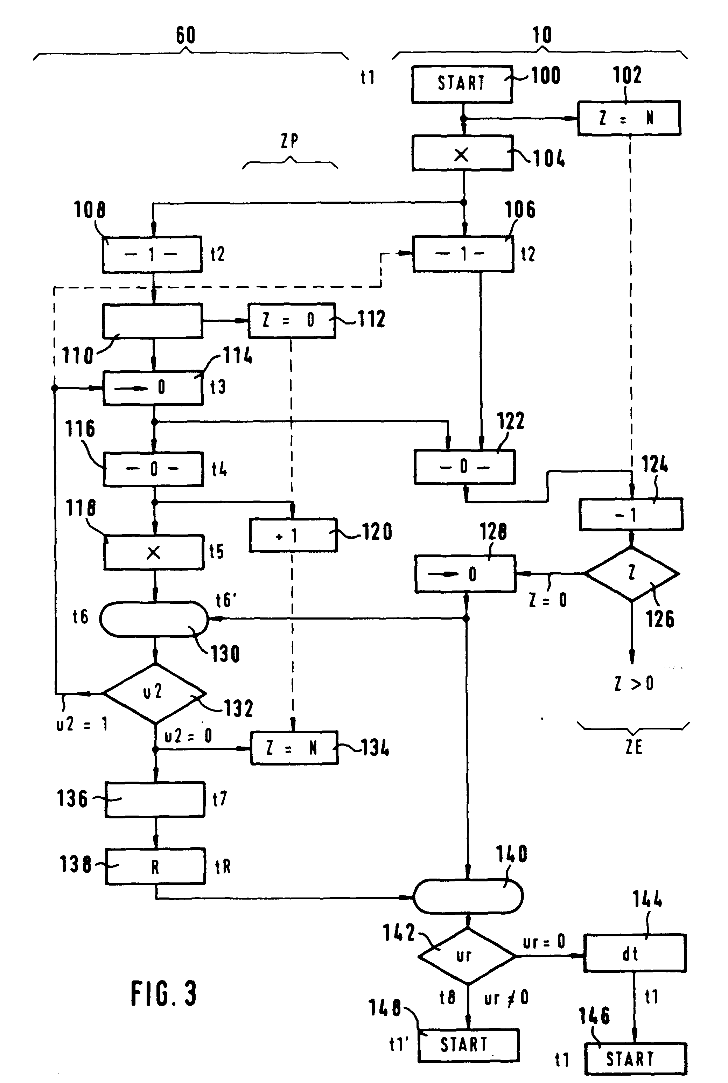

Mit der vom Codierer 20 gelieferten Zahl N wird in der Ausgangssteuerschaltung 25 beispielsweise ein Abwärtszähler ZE (vgl. Fig. 3) auf diese Zahl voreingestellt, der im Laufe der Telegrammübertragung so lange abwärts gezählt wird, bis der Zählerinhalt (= Z) Null ist. Das Abwärtszählen erfolgt jedes Mal dann, wenn in der Ausgangssteuerschaltung 25 ein Eins-Nullpegel-Übergang des Ausgangsanschlusses 12 festgestellt wird. Zu diesem Zweck ist dessen jeweiliges Potential über einen Fühler 30, der eventuell auch eine Schwellwertstufe enthält, als Signal der Ausgangssteuerschaltung 25 zugeführt. Wenn der Zählerstand Null ist, dann wird der Schalttransistor 26 durchgeschaltet, so daß der Ausgangsanschluß 12 niederohmig auf das Massepotential gezogen wird. Der Beginn eines neuen Telegramms, der vom Codierer 20 der Ausgangssteuerschaltung 25 durch eine Zahl N größer/gleich Eins gemeldet wird, löst in der Ausgangssteuerschaltung die Freigabe des Schalttransistors 26 aus, allerdings nicht bevor das Sperrintervall dt abgelaufen ist.

Es wird darauf hingewiesen, daß die Signalquelle 15 sowohl ein elektromechanisches Element und/oder ein vollelektronischer Schaltkreis sein kann, der durch mitintegrierte Schaltungsfunktionen eine eigene Signalverarbeitung aufweist. Beispielsweise kann ein derartiger Geber oder Sensor mit elektronischen Näherungsschaltern, Hallelementen, Temperaturaufnehmern und dergleichen ausgerüstet sein, bei denen die Signalquelle ohne elektromechanische Schalter auskommt, deren Lebensdauer und Zuverlässigkeit in der Regel eingeschränkt sind. Bei den vollelektronischen Signalquellen kann die zugehörige Elektronik dann ebenfalls über die interne Spannungsstufe 50 gespeist werden. Eine besonders vorteilhafte Anwendung ist beispielsweise der Ersatz von elektromechanischen Dreh- oder Schiebepotentiometern, z.B. für die Lautstärkeregelung, durch einen derartigen Geber. Vorteilhafte Anwendungsbereiche ergeben sich beispielsweise auch im Kraftfahrzeug, wenn Einstelleinrichtungen am Amaturenbrett mit einem zentralen Steuerprozessor zusammengeschaltet werden müssen.

Zum Hochziehen auf den Einspegel dient in Fig. 1 als Schaltungsmittel ein externer pull-up-Widerstand 90, der mit einem Anschluß an der Eindrahtverbindung 95 und mit dem anderen Anschluß an der positiven Versorgungsspannung VDD liegt. Selbstverständlich kann dieser Widerstand auch Teil der Eingabeschaltung 10 oder des Prozessors 60 sein. In jedem Fall, auch im externen, muß jedoch gewährleistet sein, daß die Zwangssteuerung auf den Nullpegel wesentlich niederohmiger ist als der jeweilige Wert des pull-up-Widerstandes.

Eine aktive Steuerung des pull-up-Widerstandes mittels eines Transistors 91, der insbesondere durch die Ausgangs-Steuerschaltung 25 gesteuert wird, ist ebenfalls möglich. Dies ergibt den zusätzlichen Vorteil, daß im üblichen Ruhezustand - die Eindrahtverbindung befindet sich auf dem Nullpegel - kein Querstrom durch den pull-up-Widerstand fließen kann.

In Fig. 2 sind einige typische Signale im Zeitdiagramm dargestellt, die die Funktionsweise der Schaltungsanordnung nach Fig. 1 verdeutlichen. Die einzelnen Zeitdiagramme a bis h sind dabei in gleichem Zeitmaßstab untereinander angeordnet, so daß die zeitliche Abfolge erkennbar wird.

Im Zeitdiagramm a ist das invertierte Ansteuersignal $\overline{u1}$ des Schalttransistors 26 dargestellt. Wenn der dargestellte Verlauf im Zeitdiagramm a auf den Ausgangsanschluß 12 bezogen wird, dann ist der erste Spannungspegel 1 als schwebender Zustand des Ausgangsanschlusses 12 anzusehen. Das Telegramm T beginnt zum Zeitpunkt t1 durch Freigabe des Ausgangsanschlusses 12 und endet etwa zum Zeitpunkt t7 durch die zwangsweise Durchschaltung des Ausgangsanschlusses 12 auf das Massepotential 0. Dem Telegramm T schließt sich das Sperrintervall dt an, das beispielsweise 1 ms dauern kann.

Im Zeitdiagramm b ist der jeweilige Potentialzustand u2 der Eindrahtverbindung 95 dargestellt, und zwar wenn als Telegramm T die Zahl N = 3 übertragen wird. Das Potential der Eindrahtverbindung 95 wird dabei durch den pull-up-Widerstand 90 auf den Einspegel gezogen und erreicht diesen zum Zeitpunkt t2. Im Prozessor 60 wird der Einspegel erkannt und die Eindrahtverbindung 95 zum Zeitpunkt t3 durch die Ausgangsstufe 65 zwangsweise auf den Nullpegel gezogen. Dies wird etwa zum Zeitpunkt t4 erreicht. Ab diesem Zeitpunkt t4 wird auch im Geber 10 der Eins-Null-Übergang erkannt, wodurch der Abwärtszähler ZE um eine Einheit zurückgezählt wird. Zum Zeitpunkt t5 wird die Zwangssteuerung des Prozessoranschlusses 68 freigegeben, so daß die Eindrahtverbindung 95 durch den pull-up-Widerstand 90 wieder auf den Einspegel gezogen werden kann, der zum Zeitpunkt t6 erreicht wird. Innerhalb des Telegramms T werden auf diese Weise drei Impulse übertragen, wobei nochmals darauf hingewiesen wird, daß die Steuerung und der zeitliche Ablauf ausschließlich durch den Prozessor 60 erfolgt. Das Telegrammende wird im Prozessor dadurch erkannt, daß der Prozessor am Abfragezeitpunkt t6' anstatt des Einspegels den Nullpegel erkennt, vgl. auch Zeitdiagramm h.

Im Zeitdiagramm c ist ein zum Zeitdiagramm b ähnlicher Potentialverlauf u2 der Eindrahtverbindung 95 dargestellt, wobei der einzige Unterschied darin besteht, daß im Sperrintervall dt die Eindrahtverbindung durch einen Gegentaktausgang 65 des Prozessors 60 zwangsweise in den Einszustand gezogen wird. Dies erzeugt einen Reset-Impuls R zum Zeitpunkt tR, der mittels einer mit dem Vergleicher 35 realisierten Kollisionserkennungsschaltung in der Eingabeschaltung 10 erkannt wird und das Sperrintervall dt beendet. Die Bus-Kollision entsteht dadurch, daß die Gegentaktstufe 65 die Eindrahtverbindung 95 niederohmig hochzieht, und im Gegensatz dazu der Schalttransistor 26 die Eindrahtverbindung auf das Massepotential herunterzieht. Ein allfälliger Kurzschluß zwischen der positiven Versorgungsspannung VDD und dem Masseanschluß 13 wird durch den Entkoppelwiderstand 27 verhindert. Durch die Auswertung der Spannungsdifferenz ur über diesem Entkoppelwiderstand 27 kann die vorhandene Bus-Kollision erkannt und das Sperrintervall dt beendet werden. Die Messung der Spannungsdifferenz erfolgt mittels des Vergleichers 35. Die Spannungsdifferenz ur bei einer Bus-Kollision ist in der Diagrammzeile e dargestellt. Der Resetimpuls R kann beispielsweise ein Flipflop in der Ausgangssteuerstufe 25 zurücksetzen, das beim Telegrammende vom Zeitgeber 40 zuvor gesetzt wurde.

Im Zeitdiagramm d ist die Ansteuerspannung u3 für die Ausgangsstufe 65 dargestellt. Das zwangsweise Herunterziehen des Prozessoranschlusses 68 auf das Massepotential erfolgt erstmalig zum Zeitpunkt t3 und wird zum Zeitpunkt t5 beendet. Innerhalb des Telegramms T erfolgt dies noch zwei weitere Male, da die zu übertragende Zahl N = 3 ist.

Im Zeitdiagramm e ist die Spannungsdifferenz ur über dem Entkoppelwiderstand 27 dargestellt, die lediglich im Falle des Reset-Impulses R einen von Null abweichenden Wert zeigt. Die Zwangssteuerung auf den Einspegel wird zum Zeitpunkt t3' aufgehoben, wodurch die Bus-Kollision ebenfalls aufgehoben wird. Frühestens zum Zeitpunkt t8 kann der Geber 10 die Übertragungsabsicht eines neuen Telegramms dem Prozessor 60 mitteilen.

Das Zeitdiagramm f gibt die Dauer und Lage des Telegramms Tp in der Datenverarbeitungseinrichtung 80 an, das gegenüber dem Telegramm T des Gebers 10 zeitlich verschoben ist, vgl. Zeitdiagramm a. Dies erfolgt, weil im Prozessor 60 der Telegrammanfang frühestens zum Zeitpunkt t2 und das Telegrammende frühestens zum Zeitpunkt t6' erkannt werden können. Dies hängt mit der zeitlichen Folge von Zwangssteuerung und Abfrage im Prozessor 60 zusammen.

Im Zeitdiagramm g wird im Vergleich zum Zeitdiagramm a anhand des invertierten Steuersignals $\overline{u1}$ Das Telegramm T und das durch den Reset-Impuls R verkürzte Sperrintervall tv dargestellt. Das neue Telegramm wird dabei zum Zeitpunkt t1' dem Prozessor angekündigt.

Im Zeitdiagramm h wird das Ausgangssignal u4 der Fühlerschaltung 70 dargestellt, das zugleich die Impulse bildet, die der Datenverarbeitungseinrichtung 80 als codierte Zahl N zugeführt sind. Die Übertragungszeit für einen Impuls liegt je nach der Taktzeit des Prozessors in der Größenordnung von 30 Mikrosekunden. Diese Zeit ist in der Regel klein gegen die Dauer des Sperrintervalls, von beispielsweise 1 ms. Andererseits ist die Übertragung schnell genug, um langsam ablaufende Vorgänge zu übertragen, die insbesondere bei manuellen Einstellvorgängen auftreten.

Fig. 3 zeigt das schematische Ablaufdiagramm, das vom Geber 10 ausgelöst und auch beendet wird. Teil der Ausgangssteuerschaltung 25 ist dabei ein in Fig. 1 nicht dargestellter Abwärtszähler ZE, der in der Startphase durch den Codierer 20 auf die Zahl N voreingestellt wird, wobei N diejenige Zahl ist, die der Codierer aus den zugeführten Eingabesignalen si bestimmt. Die gedachte Zeitachse in Fig. 3 verläuft von oben nach unten, so daß horizontal auf gleicher Höhe gezeichnete Blöcke etwa auch zur gleichen Zeit aktiviert werden. Gegebenenfalls sind die Zeitangaben von Fig. 2 übernommen und stehen neben den jeweiligen Blöcken. Dem Abwärtszähler ZE im Geber 10 entspricht ein Aufwärtszähler ZP im Prozessor 60, der Teil der Verarbeitungseinrichtung 80 ist und dort in der Regel lediglich als Unterprogramm realisiert ist. Das Ablaufdiagramm der Fig. 3 dient im wesentlichen der Verdeutlichung der ineinandergreifenden Funktionsabläufe des Gebers und des Prozessors.

Dem Start 100 zum Zeitpunkt t1 folgt (sofern es noch nicht geschehen ist) die Voreinstellung des Abwärtszählers ZE auf den Wert N, vgl. Block 102. Der nächste Schritt 104 ist die Freigabe des Ausgangsanschlusses 12. Damit geht die Eindrahtverbindung 95 vom Nullpegel auf den Einspegel. Dieser Pegel wird frühestens zum Zeitpunkt t2 im Prozessor und im Geber 10 (Block 108 bzw. 106) erkannt. Im Prozessor löst der Einspegel eine Übernahmeroutine aus (Block 110), die beispielsweise den Aufwärtszähler ZP im Prozessor auf Null setzt (Block 112). Der nächste Schritt 114 ist die Zwangssteuerung des Prozessorausganges 68 auf den Nullpegel, die zum Zeitpunkt t3 ausgelöst wird. Das Erkennen des zwangsweise gesteuerten Eins-Null-Übergangs wird etwa zum Zeitpunkt t4 im Prozessor (Block 116) und im Geber (Block 122) erkannt. Dies hat im Prozessor zur Folge, daß der Zählerinhalt Z um die Zahl "1" erhöht wird (Block 120) und im Geber der Zählerinhalt Z um die Zahl "1" erniedrigt wird (Block 124). Als nächster Schritt 118 wird zum Zeitpunkt t5 die Zwangssteuerung des Prozessorausgangs 68 auf den Nullpegel aufgehoben. Die Eindrahtverbindung 95 kann dabei durch die Schaltungsmittel 90 auf den Einspegel hochgezogen werden oder wird gegebenenfalls durch den Ausgangsanschluß 12 auf dem Nullpegel festgehalten. Der logische Zustand der Schalterstufe 26, 27 im Geber 10 ist mit dem Zählerstand des Abwärtszählers ZE verkoppelt und erfordert somit eine Überprüfung (Block 126) des Zählerinhaltes. Wenn der Zählerinhalt größer als Null ist, bleibt die Schalterstufe 26, 27 gesperrt. Wenn der Zählerinhalt Z jedoch den Wert Null erreicht hat, dann wird die Schalterstufe 26, 27 sofort auf den Nullpegel durchgeschaltet (Block 128). Der Eins- oder der prioritätshöhere Nullpegel wird von der Eindrahtverbindung bis zum Meßzeitpunkt t6 bzw. t6' übernommen (Block 130). Im nächsten Schritt 132 stellt der Prozessor 60 fest, welchen Spannungspegel die Eindrahtverbindung 95 aufweist. Der jeweilige Spannungspegel hat im Prozessor folgende logische Entscheidung zur Folge: Bei einem Einspegel erfolgt ein Rücksprung auf den Funktionsblock 114 und bei einem Nullpegel erfolgt als nächster Schritt 134 die Übernahme des Zählerinhaltes Z als übertragene Zahl N (Block 134). Eine weitere Folge dieser Pegelüberprüfung ist, daß im Prozessor ab dem Zeitpunkt t6' das Telegrammende erkannt worden ist (Block 136). Damit ist innerhalb des Sperrintervalls dt die Auslösung des Reset-Impulses R zu einem beliebigen Zeitpunkt tR möglich (Block 138). Der Reset-Impuls und der vorhandene Nullpegel-Schaltzustand auf der Eindrahtverbindung (vgl. Block 128) überlagern sich und bilden die Bus-Kollision (Block 140). Mittels der Bus-Kollisionserkennungsschaltung 35 wird im Sperrintervall dt die Spannungsdifferenz ur überwacht (Block 142). Ist keine Spannungsdifferenz vorhanden, dann läuft die gesamte Dauer des Sperrintervalls dt ab (Block 144), bevor ein neuer Startvorgang (Block 146) ab dem Zeitpunkt t1 ausgelöst werden kann. Ist die Spannungsdifferenz ur jedoch ungleich Null, dann wird zum Zeitpunkt t8 das Sperrintervall dt abgebrochen und ein neuer Startvorgang (Block 148) kann ab dem Zeitpunkt tl' ausgelöst werden.

## Patentansprüche

1. Verfahren, um bei einem seriellen Bussystem mit einer Eindrahtverbindung den Anschluß eines Gebers (10) mittels der Eindrahtverbindung (95) an einen Prozessor (60) zu bewirken, gekennzeichnet durch folgende Merkmale:

   - der Geber (10) bildet mittels eines Codierers (20) aus jeweils vorhandenen Eingabesignalen (si) eine Zahl, die als Impulsfolge mittels eines ersten und zweiten Spannungspegels (1, 0) auf der Eindrahtverbindung (95) übertragen wird,

   - der Geber (10) zeigt dem Prozessor (60) die Übertragungsabsicht eines Telegramms (T) dadurch an, daß ab einem ersten Zeitpunkt (t1) der Geber seinen Ausgangsanschluß (12) freigibt, der zuvor die Eindrahtverbindung (95) auf dem zweiten Spannungspegel (0) festgehalten hat,

   - die freigegebene Eindrahtverbindung (95) wird durch Schaltungsmittel (90, 91) auf den ersten Spannungspegel (1) gezogen, der im Prozessor (60) ab einem zweiten Zeitpunkt (t2) erkannt wird und eine Übernahmeroutine auslöst, in der die Anzahl (N) der übertragenen Impulse ermittelt wird,

   - das dem zweiten Zeitpunkt (t2) folgende Intervall mit dem ersten Spannungspegel (1) beendet der Prozessor (60) an einem dritten Zeitpunkt (t3) mittels einer Zwangssteuerung der Eindrahtverbindung (95) auf den zweiten Spannungspegel (0), der bei einem vierten Zeitpunkt (t4) erreicht wird, wodurch die Übertragung des ersten Impulses abgeschlossen wird,

   - ab einem fünften Zeitpunkt (t5) beendet der Prozessor (60) die Zwangssteuerung und gibt die Eindrahtverbindung (95) frei, die bis zu einem sechsten Zeitpunkt (t6 bzw. t6') folgende Spannungspegel annimmt:

     -- entweder den ersten Spannungspegel (1), wenn der Ausgangsanschluß (12) des Gebers (10) immer noch freigeschaltet ist

     -- oder den zweiten Spannungspegel (0), wenn der Freischaltzustand des Ausgangsanschlusses (12) beendet ist, weil die erforderliche Anzahl (N) von Impulsen bereits übertragen wurde,

   - der Prozessor (60) erkennt ab dem sechsten Zeitpunkt (t6', t6) den zweiten bzw. ersten Spannungspegel (0 bzw. 1) auf der Eindrahtverbindung (95) und wertet in einer Datenverarbeitungseinrichtung (80) diese Information als Telegrammende bzw. als einen weiteren Impuls aus,

   - die Trennung von Telegrammende und neuem Telegrammanfang durch den Geber (10) erfolgt mittels eines Sperrintervalls (dt), in dem der Ausgangsanschluß (12) niederohmig auf dem zweiten Spannungspegel (0) gehalten wird, und

   - die Dauer des Sperrintervalls (dt) ist dabei mindestens so lang wie die Zeit, die der Prozessor (60) zwischen dem Beginn der Zwangssteuerung und der Erkennung des jeweiligen Spannungspegels (1, 0) auf der Eindrahtverbindung (95) maximal benötigt.

2. Verfahren nach Anspruch 1, dadurch gekennzeichnet, daß das Sperrintervall (dt) im Geber (10) abgebrochen wird, wenn der Prozessor (60) innerhalb des Sperrintervalls eine Bus-Kollision mittels eines Resetimpulses (R) erzeugt, der im Geber (10) mittels einer Kollisionserkennungsschaltung (35) erkannt wird.

3. Schaltungsanordnung zur Durchführung des Verfahrens nach Anspruch 1 mit einem eine Signalquelle (15) enthaltenden Geber (10), einem Prozessor (60), einer Eindrahtverbindung (95), die einen Ausgangsanschluß (12) des Gebers mit einem als Eingang /Ausgang dienenden Prozessoranschluß (68) verbindet, und mit Schaltungsmitteln (90, 91), die die Eindrahtverbindung (95) auf einen ersten Spannungspegel (1) ziehen, gekennzeichnet durch folgende Merkmale:

   - die Ausgangssignale der Signalquelle (15) sind mittels eines Codierers (20) in eine Zahl (N) umgewandelt die einer Ausgangssteuerschaltung (25) zugeführt ist,

   - an die Ausgangssteuerschaltung (25) ist eine mit einem Ausgangsanschluß (12) verbundene Schalterstufe (26, 27) angeschlossen, die den Ausgangsanschluß (12) hochohmig schaltet oder niederohmig auf einen zweiten Spannungspegel (0) legt,

   - die Ausgangssteuerschaltung (25) ist ferner mit einem Zeitgeber (40) verbunden und über einen Fühler (30) und einen Vergleicher (35) mit dem Ausgangsanschluß (12) gekoppelt,

- der Prozessor (60) enthält eine Eingangs/Ausgangs-Steuereinrichtung (75), die mit einer Datenverarbeitungseinrichtung (80) und einer Fühlerschaltung (70) gekoppelt ist und den Prozessoranschluß (68) hochohmig oder niederohmig schaltet,

wobei im niederohmigen Schaltzustand von den beiden Spannungspegeln (1, 0) mindestens der zweite Spannungspegel (0) einstellbar ist.

4. Schaltungsanordnung nach Anspruch 3, dadurch gekennzeichnet, daß die Schaltungsmittel, die die Eindrahtverbindung (95) auf einen ersten Spannungspegel (1) ziehen, ein aktives Schaltelement (91) enthalten, das von der Eingangs/Ausgangs-Steuereinrichtung (75) oder der Ausgangssteuerschaltung (25) geschaltet ist.

5. Schaltungsanordnung nach Anspruch 3, gekennzeichnet durch folgende Merkmale:

- die an die Ausgangssteuerschaltung (25) angeschlossene Schalterstufe (26, 27) weist zwischen einer Schalteinrichtung (26) und dem Ausgangsanschluß (12) einen Entkoppelwiderstand (27) auf und

- die Spannungsdifferenz am Entkoppelwiderstand (27) ist einem Vergleicher (35) zugeführt, dessen Ausgangssignal eine Bus-Kollision anzeigt und in der-Ausgangssteuerstufe (25) ein Reset bewirkt, der die Ankündigung eines neuen Telegramms (T) freigibt.

6. Schaltungsanordnung nach Anspruch 3, dadurch gekennzeichnet, daß der Geber (10) als Signalquelle (15) einen mechanischen Drehgeber enthält, der bei Betätigung Rechts- oder Linkslaufsignale an den Codierer (20) liefert.

7. Schaltungsanordnung nach Anspruch 6, dadurch gekennzeichnet, daß der Drehgeber ferner Signale über eine jeweilige axiale Position an den Codierer (20) liefert.

8. Schaltungsanordnung nach Anspruch 3, dadurch gekennzeichnet, daß der geber (10) mindestens teilweise als monolithisch integrierte Halbleiterschaltung ausgeführt ist.

9. Schaltungsanordnung nach Anspruch 8, dadurch gekennzeichnet, daß die monolithisch integrierte Halbleiterschaltung mindestens einen monolithisch integrierten Sensor als Signalquelle (15) enthält.

**Claims**

1. A method of causing a transmitter (10) in a serial bus system with a single-wire line to be connected to a processor (60) by the single-wire line (95), <u>characterized by the following features:</u>

- By means of an encoder (20), the transmitter (10) forms from input signals (si) applied to the encoder (20) a number which is transmitted as a pulse sequence over the single-wire line (95) by means of a first voltage level (1) and a second voltage level (0);

- the transmitter (10) indicates to the processor (60) its intention to transmit a message (T) by unblocking, from a first instant (tl), its output terminal (12), which previously held the single-wire line (95) at the second voltage level (0);

- the unblocked single-wire line (95) is pulled by circuit means (90, 91) to the first voltage level (1), which is detected in the processor (60) from a second instant (t2) and initiates an acceptance routine in which the number (N) of pulses transmitted is determined;

- the interval with the first voltage level (1) which follows the second instant (t2) is terminated by the processor (60) at a third instant (t3) by pulling the single-wire line (95) to the second voltage level (0), which is reached at a fourth instant (t4), whereby the transmission of the first pulse is completed;

- from a fifth instant (t5), the processor (60) terminates the pull-down and unblocks the single-wire line (95), which assumes the following voltage levels until a sixth instant (t6 or t6'):

-- either the first voltage level (1) if the output terminal (12) of the transmitter (10) is still enabled,

-- or the second voltage level (0) if the enabled state of the output terminal (12) has been terminated because the required number (N) of pulses has already been transmitted;

- from the sixth instant (t6', t6), the processor (60) detects the second or first voltage level (0 or 1) on the single-wire line (95) and identifies this information in a data-processing device (80) as the end of a message or as a further pulse, respectively;

- the transmitter (10) separates the end of the message and the beginning of a new message by means of a lock interval (dt) in which the output terminal (12) is held at the second voltage level (0), and

- the duration of the lock interval (dt) is at least as long as the maximum time required by the processor (60) between the beginning of the pull-down and the detection of the respective voltage level (1, 0) on the single-wire line (95).

2. A method as claimed in claim 1, characterized in that the lock interval (dt) is terminated in the transmitter (10) if within the lock interval the processor (60) generates a bus collision by means of a reset pulse (R) which is detected in the transmitter (10) by means of a collision detection circuit (35).

3. A circuit arrangement for carrying out the method claimed in claim 1, comprising a transmitter (10) including a signal source (15), a processor (60), a single-wire line (95) which connects an output terminal (12) of the transmitter to an input/output port (68) of the processor, and circuit means (90, 91) which pull the single-wire line (95) to a first voltage level (1), <u>characterized by the following features:</u>

- The output signals of the signal source (15) are converted by means of an encoder (20) into a number (N) which is applied to an output control circuit (25);

- connected to the output control circuit (25) and to the output terminal (12) is a switch stage (26, 27) which switches the output terminal (12) to a high-impedance state or connects it via a low-impedance path to a second voltage level (0);

- the output control circuit (25) is also connected to a timer (40) and, via a sensor (30) and a comparator (35), to the output terminal (12);

- the processor (60) includes an input/output controller (75) which is coupled to a data-processing device (80) and a sensor circuit (70) and switches the processor port (68) to a high- or low-impedance state, at least the second (0) of the two voltage levels (1, 0) being settable in the low-impedance state.

4. A circuit arrangement as claimed in claim 3, characterized in that the circuit means which pull the single-wire line (95) to a first voltage level (1) include an active switching element (91) which is switched by the input/output controller (75) or the output control circuit (25).

5. A circuit arrangement as claimed in claim 3, characterized by the following features:

- The switch stage (26, 27), which is connected to the output control circuit (25), includes a decoupling resistor (27) between a switching device (26) and the output terminaL (12), and

- the voltage difference across the decoupling resistor (27) is fed to a comparator (35) whose output indicates a bus collision and causes in the output control stage (25) a reset which enables the announcement of a new message (T).

6. A circuit arrangement as claimed in claim 3, characterized in that the signal source (15) in the transmitter (10) is a mechanical synchro which, when operated, provides clockwise- or counterclockwise-rotation signals to the encoder (20).

7. A circuit arrangement as claimed in claim 6, characterized in that the synchro further provides the encoder (20) with signals indicating a respective axial position.

8. A circuit arrangement as claimed in claim 3, characterized in that the transmitter (10) is implemented, at least in part, as a semiconductor monolithic integrated circuit.

9. A circuit arrangement as claimed in claim 8, characterized in that the semiconductor monolithic integrated circuit comprises at least one monolithic integrated sensor as the signal source (15).

## Revendications

1. Procédé pour réaliser, dans le cas d'un système de bus série avec liaison à un fil, la connexion d'un transmetteur (10) à un processeur (60) au moyen de la liaison à un fil (95), <u>caractérisé par les caractéristiques suivantes :</u>

- le transmetteur (10) forme, au moyen d'un codeur (20) , à partir de signaux d'entrée (si) existant, un nombre qui est transmis sous forme d'une suite d'impulsions au moyen d'un premier et d'un second niveaux de tension (1, 0) sur la liaison à un fil (95),

- le transmetteur (10) indique au processeur (60) l'intention de transmission d'un télégramme (T) par le fait que, à partir d'un premier instant (t1), le transmetteur libère sa connexion de sortie (12) qui, auparavant, a maintenu la liaison à un fil (95) au deuxième niveau de tension (0),

- la liaison à un fil (95) libérée est amenée par des moyens de commutation (90, 91) au premier niveau de tension (1) qui, à partir d'un deuxième instant (t2), est reconnu dans le processeur (60) et déclenche une routine de prise en charge dans laquelle le nombre (N) des impulsions transmises est déterminé,

- le processeur (60) met fin à l'intervalle suivant le deuxième instant (t2) avec le premier niveau de tension (1) à un troisième instant (t3) au moyen d'une commande forcée de la liaison à un fil (95) au deuxième niveau de tension (0) qui est atteint à un quatrième instant (t4), grâce à quoi la transmission de la première impulsion est arrêtée,

- à partir d'un cinquième instant (t5), le processeur (60) met fin à la commande forcée et libère la liaison à un fil (95) qui prend les niveaux de tension suivants jusqu'à un sixième instant (t6, respectivement (6') :

  -- soit le premier niveau de tension (1) si la connexion de sortie (12) du transmetteur (10) est encore libérée,
  -- soit le deuxième niveau de tension (0) si l'état de libération de la connexion de sortie (12) est arrêté parce que le nombre (N) nécessaire d'impulsions a déjà été transmis,

- le processeur (60) reconnaît, à partir du sixième instant (t6, t6') le deuxième niveau de tension (0), respectivement le premier niveau de tension (1), sur la liaison à un fil (95) et interprète cette information dans un dispositif de traitement de données (80) comme étant la fin du télégramme, respectivement une autre impulsion,

- la séparation entre la fin du télégramme et le début d'un nouveau télégramme par le transmetteur (10) s'effectue au moyen d'un intervalle de fermeture (dt) pendant lequel la connexion de sortie (12) est maintenue à une faible impédance au deuxième niveau de tension (0), et

- la durée de l'intervalle de fermeture (dt) est, dans ce cas, au moins aussi longue que le temps que nécessite au maximum le processeur (60) entre le début de la commande forcée et la reconnaissance du niveau de tension respectif (1, 0) sur la liaison à un fil (95)

2. Procédé selon la revendication 1, caractérisé en ce que l'intervalle de fermeture (dt) est interrompu dans le transmetteur (10) quand le processeur (60) produit, à l'intérieur de l'intervalle de fermeture , une collision de bus au moyen d'une impulsion de remise à l'état initial (R) qui est reconnue dans le transmetteur (10) au moyen d'un circuit de reconnaissance de collision (35).

3. Dispositif de circuit pour la mise en oeuvre du procédé selon la revendication 1, comportant un transmetteur (10) comprenant une source de signaux (15), un processeur (60), une liaison à un fil (95), qui relie une connexion de sortie (12) du transmetteur à une connexion du processeur (68) servant d'entrée/sortie, et des moyens de commutation (90, 91), qui entraînent la liaison à un fil (95) à un premier niveau de tension (1),

   caractérisé par les caractéristiques suivantes :

- les signaux de sortie de la source de signaux (15) sont transformés, au moyen d'un codeur (20), en un nombre (N) qui est transmis à un circuit de commande de sortie (25),

- au circuit de commande de sortie (25) est relié un étage de commutateurs (26, 27) qui est relié à une connexion de sortie (12) et qui commute la connexion de sortie (12) à une impédance élevée ou la met à une faible impédance à un deuxième niveau de tension (0),

- le circuit de commande de sortie (25) est relié en outre à un générateur de rythme (40) et est couplé, par l'intermédiaire d'une sonde (30) et d'un comparateur (35), à la connexion de sortie (12),

- le processeur (60) comprend un circuit de commande d'entrée/sortie (75) qui est couplé avec un dispositif de traitement de données (80) et un circuit de détection (70) et qui commute la connexion du processeur (68) à une impédance élevée ou à une faible impédance, au moins le deuxième niveau de tension (0) des deux niveaux de tension (1, 0) étant réglable à l'état de commutation à faible impédance.

4. Dispositif de circuit selon la revendication 3, caractérisé en ce que les moyens de commutation, qui amènent la liaison à un fil (95) à un premier niveau de tension (1), comprennent un élément de commutation actif (91) qui est commuté par le circuit de commande d'entrée/sortie (75) ou le circuit de commande de sortie (25).

5. Dispositif de circuit selon la revendication 3, caractérisé par les caractéristiques suivantes :

- l'étage de commutateurs (26, 27) relié au circuit de commande de sortie (25) comporte une résistance de découplage (27) disposée entre un dispositif de commutation (26) et la connexion de sortie (12) et

- la différence de tension aux bornes de la résistance de découplage (27) est envoyée à un comparateur (35) dont le signal de sortie indique une collision de bus et active, dans l'étage de commande de sortie (25), une remise à l'état initial qui libère l'annonce d'un nouveau télégramme (T).

6. Dispositif de circuit selon la revendication 3, caractérisé en ce que le transmetteur (10) contient, en tant que source de signaux (15), un capteur rotatif mécanique qui délivre au codeur (20), lors de son actionnement, des signaux de rotation à droite ou de rotation à gauche.

7. Dispositif de circuit selon la revendication 6, caractérisé en ce que le capteur rotatif délivre en outre au codeur (20) des signaux concernant une position axiale respective.

8. Dispositif de circuit selon la revendication 3, caractérisé en ce que le transmetteur (10) est réalisé, au moins partiellement, sous la forme d'un circuit intégré monolithique à semi-conducteurs.

9. Dispositif de circuit selon la revendication 8, caractérisé en ce que le circuit intégré monolithique à semiconducteurs comprend au moins un capteur intégré monolithique en tant que source de signaux (15).

FIG. 1

FIG. 2

FIG. 3